# EUROPEAN PATENT SPECIFICATION

(11) **EP 0 347 561 B1**
(45) Date of publication and mention of the grant of the patent: **16.03.1994**
(21) Application number: 89107673.9
(22) Date of filing: 27.04.1989
(51) Int. Cl.: H01R 4/26, H01R 4/58, H01R 13/22

(54) **Separable electrical connection**
Lösbare elektrische Verbindung
Connexion électrique séparable

(30) Priority: 21.06.1988 US 209667
(43) Date of publication of application: 27.12.1989
(73) Proprietor: International Business Machines Corporation, Armonk, N.Y. 10504 (US)
(72) Inventor: Cuomo, Jerome John, Lincolndale New York 10540 (US); Kang, Sung Kwon, Chappaqua New York 10514 (US); Kim, Jungihl, Peekskill New York 10566 (US); Lauro, Paul, Pomona New York 10970 (US); Miersch, Ekkehard Fritz, Mamaroneck New York 10543 (US); Ritsko, John James, Mount Kisco New York 10549 (US); Saxenmeyer, George John, Apalachin New York 13732 (US); Walker, George Frederick, New York New York 10028 (US)
(74) Representative: Schäfer, Wolfgang, Dipl.-Ing.

(56) References cited:
- DE-A- 2 816 328
- DE-B- 1 237 661
- RESEARCH DISCLOSURE. vol. 287, no. 48, 10 March 1988, HAVANT GB page 155 disclosed anonymously: "method to provide multiple dendritic contact points for high density flat on flat connector system"
- IBM TECHNICAL DISCLOSURE BULLETIN. vol. 22, no. 7, December 1979, NEW YORK US page 2706 r. babuka et al.: "LIQUID METAL / DENDRITE CONNECTOR"
- PATENT ABSTRACTS OF JAPAN vol. 12, no. 117 (C-487)(2964) 13 April 1988 & JP-A-62-240739

## Description

The invention relates to electrical connections that can be separated and then, when desired, be reconnected. The invention particularly relates to contacts for high current miniaturized applications, such as semiconductor integrated circuit chips, circuit board and cable interconnections.

As electrical equipment becomes more densely packed, the interconnections, as a result of the packing, become smaller yet the density of the packing also operates to increase the electrical current each must carry. It is further becoming increasingly desirable to be able to separate and reconnect such connections for repair and subassembly replacement purposes.

From Research Disclosure, Volume 287, No. 48, March 1988, page 155 a method of promoting electrical contact for small areas such as tabs, pads, etc. is known. The method works by the application of a substance containing irregularly shaped and randomly located dentrit formations, such as dentritic copper powder, which is solder bonded to the pad.

As the art has developed, an appreciation has grown that a connection with members that can interdigitate from each side of the contact would be useful for both retention of registration of the connection parts and current carrying capacity.

From IBM Technical Disclosure Bulletin, Volume 22, No. 7, December 1979, page 2706 a liquid metal connector system is known which employs dentrits to pierce the tarnish films that build up on the liquid metal connector. The interleaved dentrits also serve to enhance the electrical and/or mechanical innterconnection between the pads.

In U.S. Patents 2,461,980 and 3,725,844 such interdigitated connection structures are shown wherein the contact members are made up of filament groups similar to a brush.

In U.S. Patent 3,526,867 a description is provided of an interdigitated connector with interlocking properties to retain the parts.

In German patent DE 2816328 the interdigitated connector is made of a material having dendritic type protrusions that intermesh from each side of the contact.

There is however a problem in the art of damage and deterioration of the connection caused by separating and connecting of the connectors.

The invention is aimed to remedy these drawbacks.

In summary, the proposed connection is made up of an essentially planar area of conductive material on which there is provided a plurality of essentially vertical inter-digitating members protruding from the surface of and integrally fastened to the planar conductive material each having a vertical to horizontal aspect ratio that is greater than 1. The present invention is based on the insight that as the aspect ratio of the interdigitating member is greater, the horizontal stresses on the members, in separating and connecting, also increases which consequently causes damage and deterioration. Therefore the combination of the planar portion and the interdigitating members is provided with a means for accommodating stresses that are lateral with respect to the planar direction. The means of accommodating the stresses includes providing a conformal mating contact and the providing of strengthening and shock absorbing coating materials on the interdigitating members.

The invention is described in detail below with reference to the drawings in which:
FIG. 1 is a schematic illustration of the different aspect ratios of and stress on interdigitating members.
FIG. 2 is a schematic illustration of a connector wherein the mating parts are conformal.
FIG. 3 is a photomicrograph of hillock type interdigitating material.
FIG. 4 is a photomicrograph of dendritic type interdigitating material.
FIGS. 5, 6 and 7 are photomicrographs showing progressive damage due to misalignment of contacts of dendritic interdigitating material for 0, 3 and 50 separation and reconnection times, respectively.
FIG. 8 is a schematic illustration of an intermediate step in forming a conformal contact as shown in FIG. 2.
FIGS. 9 and 10 are photomicrographs showing the dendritic interdigitating member and the conformal pad member, respectively, after mating.
FIG. 11 is a schematic illustration of an interdigitated contact member where lateral stress accommodation is provided by a plated coating.
FIGS. 12 and 13 are photomicrographs of the contact of FIG. 11 using dendritic material at approximately 200X magnification, at 0 times and 50 times separation and reconnection, respectively.
FIGS. 14 and 15 are photomicrographs of the structures of FIGS. 12 and 13 at approximately 500X magnification.
FIG. 16 is a schematic illustration of lateral stress accommodation, employing a plated soft deformable and shock absorbing coating.
FIG. 17 is a schematic illustration of lateral stress accommodation, employing an interdigitating member reinforcing material.

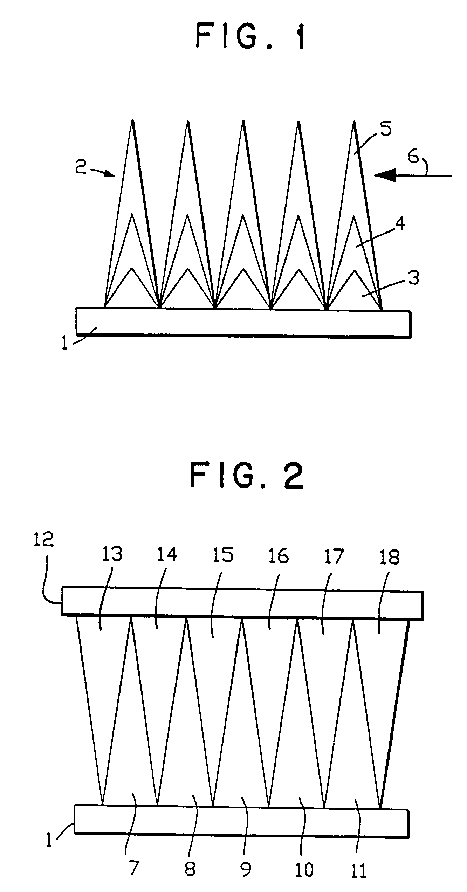

The connection according to the invention is made up, with an essentially planar area of conductive material on which there is provided a plurality of essentially vertical interdigitating members that protrude from the surface and are integrally fastened to the surface of the planar conductive material. Each of the interdigitating members has an aspect ratio greater than 1 and in accordance with the invention provision is made for accommodating horizontal stresses on the interdigitating members. The aspect ratio and the stresses are graphically illustrated in connection with FIG. 1 wherein, on the planar conductive material 1, a plurality of interdigitating members 2 are shown, each with an aspect ratio of 1, labelled element 3, of 2 labelled element 4, and of 4 labelled element 5, and with the horizontal stresses that occur, due to such matters as misalignment and other interdigitating members entering the spaces between them, shown symbolically as the arrow 6. It will be apparent that as the aspect ratio becomes larger the potential for lateral stress to damage the interdigitating members increases.

Referring next to FIG. 2, an illustration is provided of conformal mating contacts in which, one contact on the planar conductive member 1 has interdigitating members 7, 8, 9, 10 and 11, and an opposite conductive member 12 has interdigitating members 13, 14, 15, 16, 17 and 18. Such a contact accommodates the potential for horizontal stress because when the contact is taken apart and put together the contact conforms to and has a place for each part of the opposite member so that there is minimal stress on the individual interdigitating members.

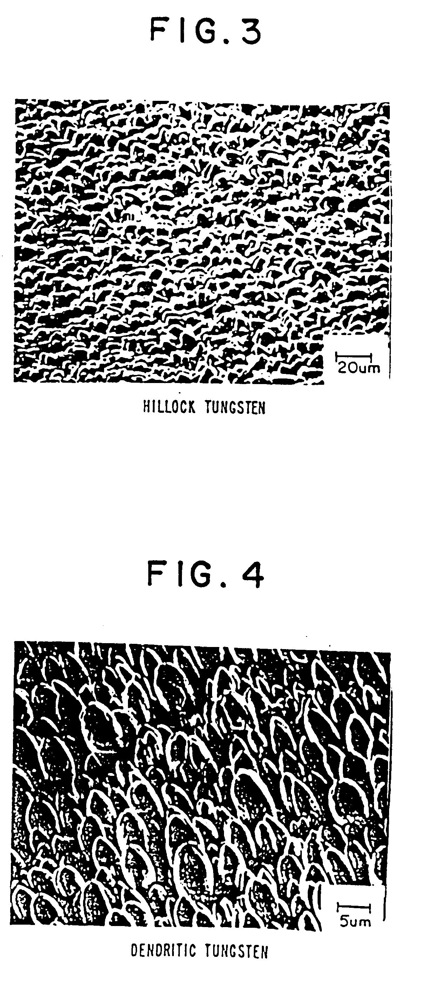

There are two general types of material that can be produced sufficiently economically, with high aspect ratios and can be placed in the confined locations for contact purposes. They are known as hillock and dendritic material as is illustrated in photomicrographs FIG. 3 and FIG. 4, respectively. The materials can be positioned on substrates to very fine dimensions. Such materials however when used as the interdigitating members are subject to damage due to the horizontal stresses described in connection with FIG. 1, produced mostly by the random nature of the interdigitating members and misalignment as the contacts are placed together.

The materials for the hillock and dendritic elements illustrated in FIGS. 3 and 4 may be taken from the group of palladium, platinum, rhodium, ruthenium. osmium and tungsten. Hillock and dendritic materials may be formed by plating wherein a lower than normal concentration of metal ions is maintained in the plating solution while the current for the electroplating takes place at a higher than normal current density. The materials of FIGS. 3 and 4 may also be formed by the hydrogen reduction of a hexaflouride of the metal to be employed, taking for an example tungsten hexafluoride. Since tungsten hexafluoride is a liquid with a high vapor pressure, its delivery to a reaction chamber is readily achievable as a gas. Purified hydrogen may be used as a carrier gas and as a reactant. Reaction generally takes place from 400° to 650° Centigrade. The hillock material is made with the same procedures as a dendritic material but for a shorter period time. The hillock material 20 is generally used for applications wherein the specifications are not as rigorous.

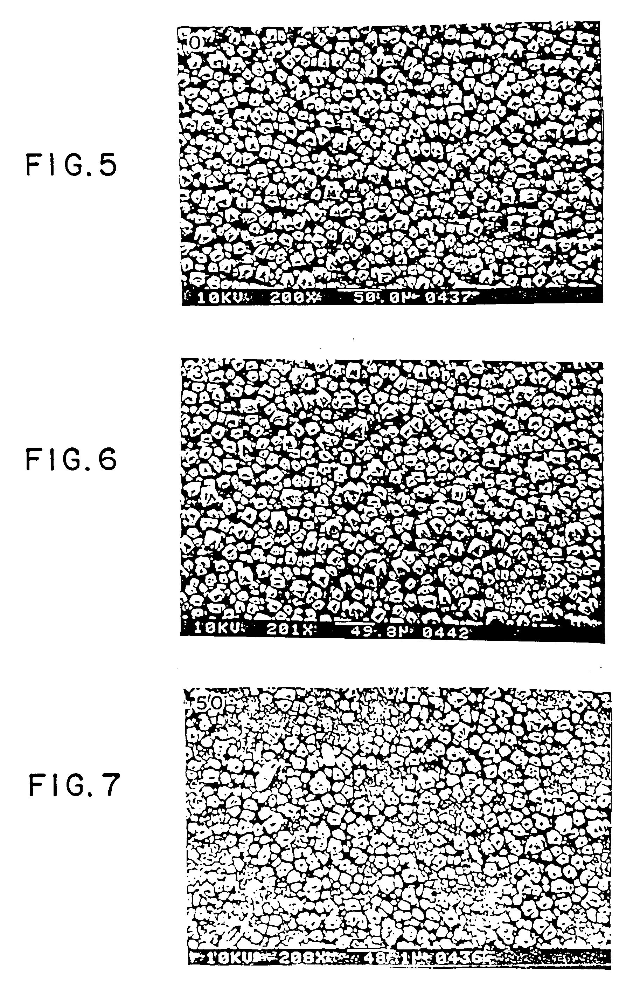

In FIGS. 5, 6 and 7, which are photomicrographs of dendritic material as shown in FIG. 4, made of tungsten, at approximately 200 times magnification, the effect of lateral stress damage is illustrated.

In FIG. 5, the starting material has not been pressed together in the form of a contact and no damage is seen. In FIG. 6, however, the contact has been pressed together three times and in the lower righthand corner some measure of damage is beginning to become apparent.

Referring next to FIG. 7, after 50 times of insertion, there are areas of damage scattered throughout the entire contact.

In accordance with the invention, an accommodation is provided to handle the stress shown in FIG. 1 that produces the damage in FIG. 7. That accommodation may take several forms. The preferred embodiment form would be to have the contact be of the conformal nature shown in FIG. 2 wherein the two sides of the contact would precisely mate. Another approach would be to provide some strengthening for the interdigitating members. Still another approach would be to provide some physical accommodating soft coating for the interdigitating members.

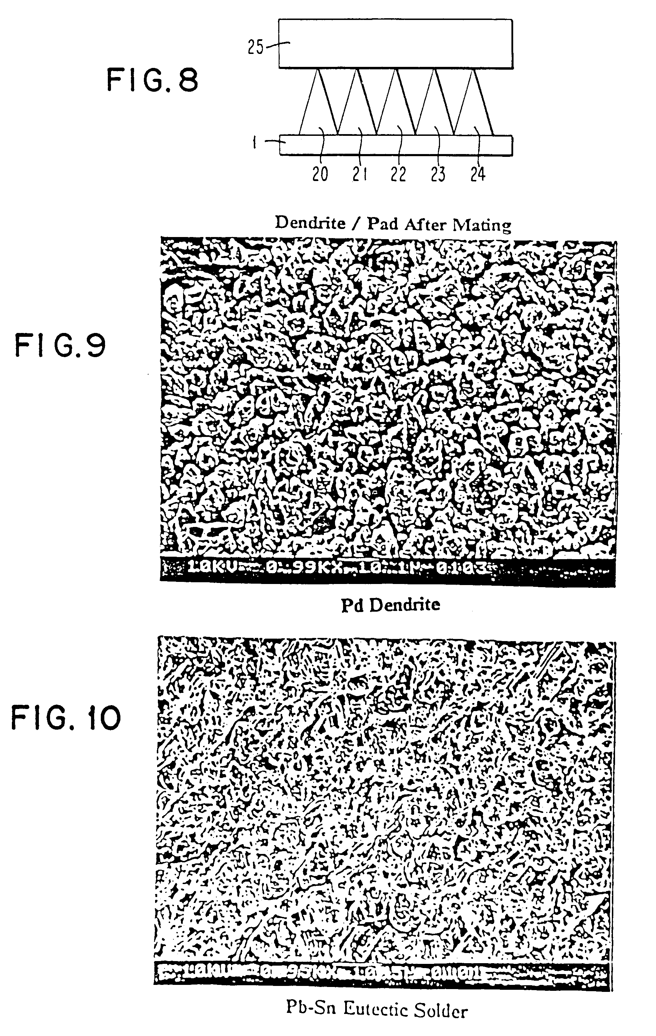

Referring to FIG. 8, there is provided an illustration of the fabrication of the preferred embodiment wherein, the planar area of conductive material 1 has an illustrative number of interdigitating members 20, 21, 22, 23 and 24 integrally attached to it and these are being pressed into a conformal metal material 25 that when the pressing is complete will have changed its shape to form a series of corresponding locations for the interdigitating members 20 through 24. This may be done by providing as the interdigitating members palladium or tungsten dendrites or the like, of 380 µm (15 mils) in height and 25-125 µm (1-5 mils) thick grown on the conductive material 1 and having the conformal pad 25 be soft or deformable, such as of lead tin eutectic solder or pure gold, or the like.

Referring next to FIGS. 9 and 10, photomicrographs with about 100 magnification of the interdigitating members and pad after mating are shown. In FIG. 9 the interdigitating members, illustrated symbolically in FIG. 8 as 20-24, are palladium dendrites. In FIG. 10, the lead tin eutectic solder pad 25 is shown. It will be apparent that the dendrites have penetrated the pad 25 and that the soft or deformable eutectic solder pad conforms to the shape of the dendrites and provides a strong mechanical bond without horizontal stresses that would provide dendrite breakage.

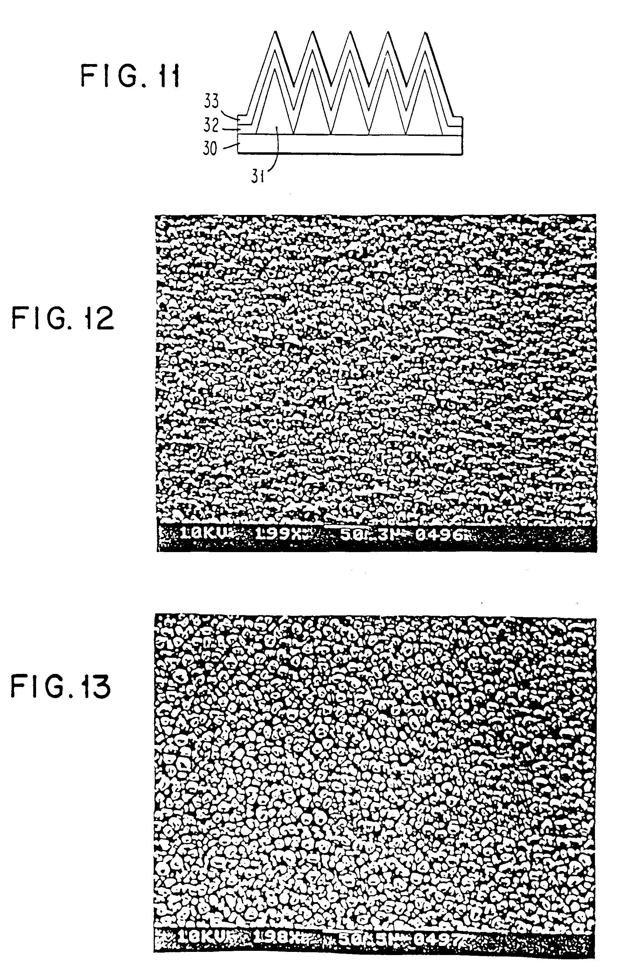

Referring next to FIG. 11, a schematic illustration is shown wherein the interdigitating members are strengthened with a coating in order to provide an accommodation for the horizontal stresses.

On the planar conductor member 30, the interdigitating members 31 are of tungsten and are provided with an adhesion coating 32 of chromium approximately 50 nm thick, covered by a strengthening coating 33 of copper about 5 microns thick. The adhesion coating is provided by plating and the copper coating is provided by sputtering.

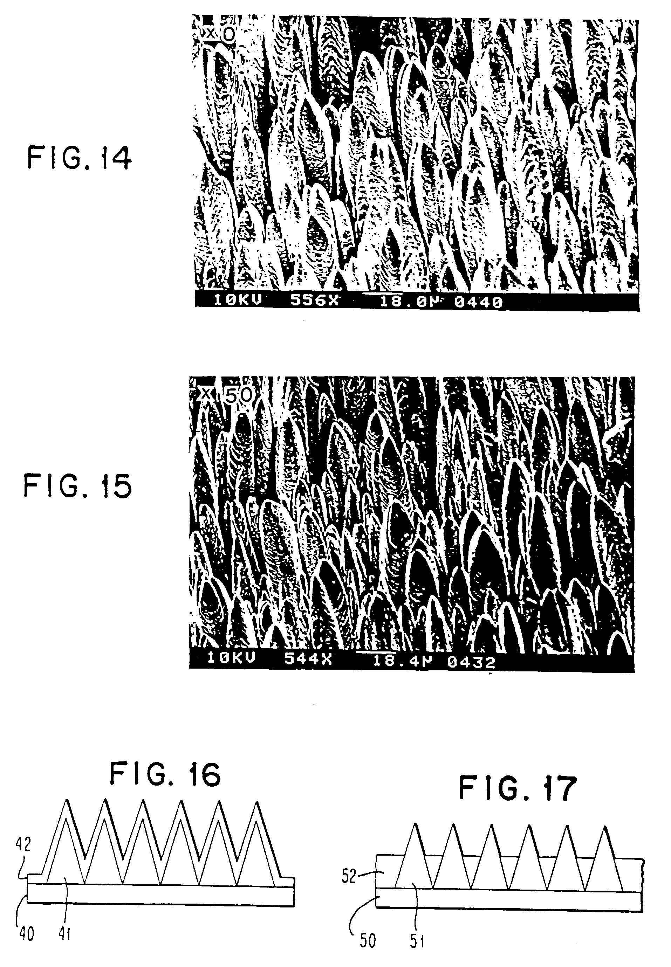

Referring next to FIGS. 12 and 13, photomicrographs of the copper strengthened tungsten dendritic structure described in connection with FIG. 11 are provided where, in FIG. 12, at about 200 times magnification, the structure is shown as manufactured and in FIG. 13, at approximately the same magnification, after about 50 times of mating with another contact at a slight off angle of registration. The strengthening coating 33 of FIG. 11, as may be seen from FIG. 13, is adequate to prevent breakage of the type shown in FIG. 7.

The protection from damage through strengthening becomes even more apparent in connection with FIGS. 14 and 15 wherein, at around 500 times magnification, in FIG. 14 the dendrites are shown as manufactured whereas, in FIG. 15 at the end of 50 times of mating, there is no indication of damage.

In FIGS. 16 and 17, two additional approaches to the accommodation of lateral stresses are schematically illustrated. In connection with FIG. 16, the accommodation is accomplished by providing a coating that serves as a displacement shock absorber to lateral stresses.

In FIG. 16, on the planar material 40, the interdigitating members 41 are positioned and over them there is placed a coating 42 that may be a soft gold base provided by a dry process such as evaporation, or by a wet process such as electroplating, the gold being sufficiently soft that in the interdigitation with another contact the gold deforms and thereby absorbs the shock to the hardened dendritic materials so as to relieve any lateral stress.

In FIG. 17, the lateral stress is accommodated through the interdigitating member 51 on the planar member 50 being reinforced with a material 52 such as a polymer. In this arrangement, the polymer acts as a stress relieving support for the interdigitating members. Clearly, since the polymer is an insulator, it will be necessary to remove it from the portions of the interdigitating members where they make contact with the other mating contact. This is conveniently done by a dry isotropic etching process such as reactive ion etching or plasma etching, which can remove the polymer material down to a selected level.

When the contact of the invention is placed in service, a force is usually applied in the form of a clamp to keep the two mating portions together although frequently in electronic equipment such items as the covering can for an integrated circuit chip perform some of the functions of retaining the contacts in position.

What has been described is a connection made up of a planar area of a conductive material having a plurality of interdigitating members protruding from the surface with a means for accommodating lateral stresses to the interdigitating members that occur from misalignment and from the interdigitating members forcing each other apart.

## Claims

1. An electrical connector comprising in combination at least one planar layer of conductive material (1), a plurality of conductive projecting members (2) positioned essentially vertical with respect to said planar layer and integrally fastened to said planar layer material, each said member having a vertical to horizontal aspect ratio that is greater than 1,
characterized by
means for accommodating stresses that are lateral with respect to the direction of said projecting members.

2. The connector of claim 1 wherein at least said members are of materials taken from the group of hillock and dendritic materials.

3. The connector of claims 1 or 2 wherein at least the material of said members is taken from the group of palladium, platinum, rhodium, ruthenium, osmium and tungsten.

4. The connector of one of the preceding claims wherein said lateral stress accommodating means includes strengthening said members.

5. The connector of claim 4 wherein said strengthening includes a plated coating (e.g. Fig. 11).

6. The connector of one of the preceding claims, in particular of claims 4 or 5 wherein the strengthening said members (31 in Fig. 11) includes an adhesion coating (32), preferably of chromium, covered by a strengthening coating (33), preferably of copper.

7. The connector of claim 6 wherein the adhesion coating (32) is provided by plating, preferably with a thickness of approximately 50 nm, and wherein the overlying strengthening coating (33) is provided by sputtering, preferably with a thickness of approximately 5 µm.

8. The connector of one of the preceding claims, in particular of one of claims 4 to 7 wherein said strengthening includes a polymer (52) at the base of each said interdigitating member (51, e.g. in Fig. 17).

9. The connector of claim 8 wherein said strengthening involves a polymer reinforcement around said dendritic protrusions.

10. An electrical connection comprising first and second connectors according to any one of the preceding claims wherein said lateral stress accommodating means is a conformal mating contact member having a corresponding indentation for each said interdigitating member (e.g. Fig. 2).

11. The connection of claim 10 wherein said conformal mating contact is of a soft deformable material.

12. The connection of claims 10 or 11 wherein the material of said conformal mating contact is taken from the group of lead-tin eutectic solder and pure gold.

## Patentansprüche

1. Elektrischer Steckverbinder, der in Verbindung miteinander mindestens eine ebene Schicht aus leitendem Material (1) und eine Vielzahl leitender, hervorstehender Glieder (2) enthält, die bezüglich der ebenen Schicht im wesentlichen senkrecht angeordnet sind und fest mit dem Material der ebenen Schicht verbunden sind, wobei jedes Glied ein Verhältnis von Höhe zu Breite größer als 1 besitzt,
gekennzeichnet durch
Mittel zum Ausgleichen von Druck, der seitlich zur Richtung der hervorstehenden Glieder auftritt.

2. Steckverbinder gemäß Anspruch 1, wobei zumindest die Glieder aus Material bestehen, die aus der Gruppe aus Hügelmaterialien und dendritischen Materialien ausgewählt werden.

3. Steckverbinder gemäß Anspruch 1 oder 2, wobei zumindest das Material der Glieder aus der Gruppe aus Palladium, Platin, Rhodium, Ruthenium, Osmium und Wolfram gewählt wird.

4. Steckverbinder gemäß Anspruch 4, wobei das Mittel zum Ausgleichen des seitlichen Drucks das Verstärken der Glieder einschließt.

5. Steckverbinder gemäß einem der vorhergehenden Ansprüche, wobei das Verstärken einen metallisierten Überzug einschließt (z. B. Fig. 11).

6. Steckverbinder gemäß einem der vorhergehenden Ansprüche, insbesondere Anspruch 4 oder 5, wobei das Verstärken der Glieder (31 in Fig. 11) einen Haftüberzug (32), vorzugsweise aus Chrom, einschließt, der von einem verstärkenden Überzug (33), vorzugsweise aus Kupfer, überzogen ist.

7. Steckverbinder gemäß Anspruch 6, wobei der Haftüberzug (32) durch Metallisieren vorzugsweise mit einer Dicke von etwa 50 nm hergestellt wird, und wobei der darüberliegende verstärkende Überzug (33) durch Sputtern vorzugsweise mit einer Dicke von etwa 5 µm hergestellt wird.

8. Steckverbinder gemäß einem der vorhergehenden Ansprüche, insbesondere einem der Ansprüche 4 bis 7, wobei das Verstärken ein Polymer (52) an der Basis jedes der ineinandergreifenden Glieder (51, z. B. in Fig. 17) einschließt.

9. Steckverbinder gemäß Anspruch 8, wobei für das Verstärken eine Polymer-Verstärkung um die dendritischen Vorsprünge verwendet wird.

10. Elektrische Verbindung mit einem ersten und zweiten Steckverbinder gemäß einem der vorhergehenden Ansprüche, wobei das Mittel zum Ausgleichen des seitlichen Drucks ein sich anpassendes Kontakt-Gegenglied ist, das für jedes der ineinandergreifenden Glieder eine entsprechende Aussparung besitzt (z. B. Fig. 2).

11. Verbindung gemäß Anspruch 10, wobei der sich anpassende Gegenkontakt aus einem weichen, verformbaren Material besteht.

12. Verbindung gemäß Anspruch 10 oder 11, wobei das Material des sich anpassenden Gegenkontakts aus der Gruppe aus eutektischem Blei-Zinn-Lot und reinem Gold ausgewählt wird.

## Revendications

1. Connecteur électrique comprenant en combinaison au moins une couche planaire de matériau conducteur (1), une pluralité d'éléments conducteurs (2) en saillie disposés de façon sensiblement verticale par rapport à ladite couche planaire et fixés solidairement à ladite couche de matériau planaire, chacun desdits éléments ayant un rapport d'apparence verticale sur horizontale supérieur à 1, caractérisé par
des moyens pour accomoder des contraintes qui sont latérales par rapport à la direction desdits éléments en saillie.

2. Connecteur selon la revendication 1, dans lequel au moins lesdits éléments sont réalisés dans des matériaux pris dans le groupe des matériaux hillock et dendritiques.

3. Connecteur selon les revendications 1 ou 2 dans lequel au moins le matériau desdits éléments est pris dans le groupe du palladium, platine, rhodium, ruthenium, osmium et tungstène.

4. Connecteur selon l'une des revendications précédentes, dans lequel lesdits moyens pour accomoder des contraintes latérales comprennent le renforcement desdits éléments.

5. Connecteur selon la revendication 4, dans lequel ledit renforcement inclus un revêtement plaqué (par exemple figure 11).

6. Connecteur selon l'une quelconque des revendications précédentes, en particulier selon les revendications 4 ou 5, dans lequel le renforcement desdits éléments (31 dans la figure 11) inclus un revêtement adhésif (32), de préference en chrome, recouvert par un revêtement de renfort (33), de préférence en cuivre.

7. Connecteur selon la revendication 6 dans lequel le revêtement adhésif (32) est obtenu par placage, de préférence sur une épaisseur d'environ 50 nm, et dans lequel le revêtement de renfort de couverture (33) est obtenu par pulvérisation, de préférence sur une épaisseur d'environ 5 micromètres.

8. Connecteur selon l'une des revendications précédentes, en particulier l'une des revendications 4 à 7, dans lequel ledit renforcement inclus un polymère (52) à la base de chacun desdits éléments imbriqués (51, par exemple dans la figure 17).

9. Connecteur selon la revendication 8 dans lequel ledit renforcement utilise un renforcement en polymère autour desdites protubérences dendritiques.

10. Connexion électrique comprenant des premiers et seconds connecteurs selon l'une quelconque des revendications précédentes dans laquelle lesdits moyens pour accomoder des contraintes latérales sont constitués par un élément de contact correspondant adapté ayant une indentation-correspondante pour chacun desdits éléments imbriqués (par exemple figure 2).

11. La connexion selon la revendication 10 dans laquelle ledit contact corespondant adapté est en matériau déformable souple.

12. La connexion selon les revendications 10 ou 11 dans laquelle le matériau dudit contact correspondant adapté est pris dans le goupe formé par la soudure eutectique plomb-étain et l'or pur.
